(19)

Europäisches
Patentamt
European
Patent Office
Office européen
des brevets

(11) **EP 1 882 978 A1**

(12) **EUROPEAN PATENT APPLICATION**

(43) Date of publication:
**30.01.2008 Bulletin 2008/05**

(51) Int Cl.:
**G02F 1/1362** *(2006.01)* **H01L 21/77** *(2006.01)*
**G02F 1/1368** *(2006.01)*

(21) Application number: **07014464.7**

(22) Date of filing: **24.07.2007**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK YU**

(30) Priority: **25.07.2006 KR 20060069646**

(71) Applicant: **Samsung Electronics Co., Ltd.**
**Yeongtong-gu**
**Suwon-city, Gyeonggi-do 442-742 (KR)**

(72) Inventors:
• **Kim, Dong-Gyu**
  **Suji-gu Yongin-si**
  **Gyeonggi-do (KR)**
• **Kim, In-Woo**
  **Giheung-gu**
  **Yongin-si**
  **Gyeonggi-do (KR)**

• **Yang, Byung-Duk**
  **Yeongtong-gu**
  **Suwon-si**
  **Gyeonggi-do (KR)**
• **Park,Min-Wook**
  **Asan-si**
  **Chungcheongnam-do (KR)**
• **Sohn, Woo-Sung**
  **Gangnam-gu**
  **Seoul (KR)**
• **Choo, Min-Hyung**
  **Seongnam-si**
  **Gyeonggi-do (KR)**
• **Jung, Kyung-Suk**
  **Iksan-si**
  **Jeonrabuk-do (KR)**

(74) Representative: **Dr. Weitzel & Partner**
**Friedenstrasse 10**
**89522 Heidenheim (DE)**

(54) **Liquid crystal display**

(57) At least one embodiment of a liquid crystal display includes a substrate, a gate conductor formed on the substrate and including a gate line (121) and a gate electrode (124), a data conductor including a data line (171) crossing the gate line and a source electrode (173) placed on the gate electrode, and a pixel electrode (191) formed on the substrate, where the data line and the source electrode are connected with a first interconnector (174) and a second interconnector (178).

FIG.3

EP 1 882 978 A1

# Description

## CROSS-REFERENCE TO RELATED APPLICATION

This application claims priority to and the benefit of Patent Application No. 10-2006-0069646 filed in the Korean Intellectual Property Office, Republic of Korea, on July 25, 2006, the entire contents of which are incorporated by reference.

## BACKGROUND OF THE INVENTION

### (a) Field of the Invention

The present invention relates to liquid crystal displays.

### (b) Description of the Related Art

A liquid crystal display is one of the most widely used types of flat panel display. The liquid crystal display typically includes two display panels each having field-generating electrodes such as pixel electrodes and a common electrode, and a liquid crystal layer interposed therebetween. The liquid crystal display may induce an electric field on a liquid crystal layer by applying a voltage to the field generating electrodes, which then determines the alignment of liquid crystal molecules in the liquid crystal layer therethrough, and thereby controls the polarization of incident light to displaying an image. Liquid crystal displays may also include a plurality of signal lines such as gate lines and data lines in order to supply a voltage to a pixel electrode by controlling a switching element connected to a pixel electrode. A thin film transistor (TFT) may be used as a switching element for each pixel in a liquid crystal display. The thin film transistor includes terminals formed of multi-layered thin films which may become shorted.

Therefore, there remains a need in the art for a liquid crystal display including thin film transistors and/or multi-layered thin films where image degradation caused by shorting may be avoided.

## SUMMARY OF THE INVENTION

One or more embodiments of the present invention provide a liquid crystal display where repair of the liquid crystal display is possible, not only when a thin film transistor become deteriorated but when also in the circumstance when a gate line and a data line are shorted. In this disclosure, the term exemplary refers to an example embodiment and not necessarily to an ideal embodiment.

An exemplary embodiment of the present invention provides a liquid crystal display including a substrate, a gate conductor formed on the substrate and including a gate line and a gate electrode, a data conductor including a data line crossing the gate line and a source electrode placed on the gate electrode, and a pixel electrode formed on the substrate, where the data line and the source electrode are connected with a first interconnector and a second interconnector.

The first interconnector and the second interconnector may be disposed with the gate line interposed therebetween. The first interconnector and the second interconnector may not overlap with the gate line. The first interconnector and the second interconnector may be disposed with a crossing point of the data line and the gate line interposed therebetween. A first cutout may be formed on the pixel electrode, where the first cutout makes an oblique angle with the gate line. The liquid crystal display may further include a common electrode disposed facing the pixel electrode., where a second cutout may be formed on the common electrode, the second cutout being substantially parallel to the first cutout. The pixel electrode may include two pairs of main edges parallel to the gate line and the data line, respectively. The pixel electrode may have a first side parallel to the gate line and a second side adjacent to the first side. The second side may be shorter than the first side. The first side may be about three times longer than the second side.

The pixel electrode may include the first sub-pixel electrode and the second sub-pixel electrode that are separate from each other. The first sub-pixel electrode may conduct a first voltage level and the second sub-pixel electrode may conduct a second voltage level, where the first voltage level of the first sub-pixel electrode and the second voltage level of the second sub-pixel electrode may be different from each other. The first sub-pixel electrode and the second sub-pixel electrode may be supplied with different data voltages obtained from a single image information. The liquid crystal display may include a first thin film transistor connected to the first sub-pixel electrode, a second thin film transistor connected to the second sub-pixel electrode, a first signal line connected to the first thin film transistor, a second signal line connected to the second thin film transistor, and a third signal line connected to the first thin film transistor and the second thin film transistor, the third signal line crossing the first signal line and the second signal line. The first thin film transistor and the second thin film transistor may be turned on according to signals received from the first signal line and the second signal line, respectively, the first and second thin film transistors may be configured to transfer signals from the third signal line. The first thin film transistor and the second thin film transistor may be turned on according to signals received from the third signal line, the first and second thin film transistors may be configured to transfer signals from the first signal line and the second signal line. The first sub-pixel electrode and the second sub-pixel electrode may be capacitively coupled. The liquid crystal display may further include the first thin film transistor connected to the first sub-pixel electrode, the first signal line connected to the first thin film transistor, and the second signal line connected to the first thin film transistor and crossing the first signal line.

Another exemplary embodiment of the present invention provides a liquid crystal display including a substrate, a gate conductor formed on the substrate and including a gate line and a gate electrode, a data conductor including a data line crossing the gate line and a source electrode placed on the gate electrode, and a pixel electrode formed on the substrate, where the data line and the source electrode are connected with a plurality of interconnectors. At least a part of the interconnectors may not overlap with the gate conductor. The interconnectors may be configured to be cut by a laser so that a voltage level may be continuously applied to the pixel electrode, where the applied voltage level may maintain the pixel electrode in an inactive state.

The scope of the present invention is defined by the claims, which are incorporated into this section by reference. A more complete understanding of embodiments of the present invention will be afforded to those skilled in the art, as well as a realization of additional advantages thereof, by a consideration of the following detailed description. Reference will be made to the appended sheets of drawings that will first be described briefly.

**BRIEF DESCRIPTION OF THE DRAWINGS**

FIG. 1 is a block diagram illustrating a liquid crystal display according to an exemplary embodiment of the present invention.

FIG. 2 is an equivalent circuit diagram illustrating a liquid crystal display device according to an exemplary embodiment of the present invention.

FIG. 3 is a layout view of a liquid crystal panel assembly according to an exemplary embodiment of the present invention.

FIG. 4 and FIG. 5 are cross-sectional views of the liquid crystal panel assembly of FIG. 3 taken along the lines IV-IV and V-V.

FIG. 6 and FIG. 7a show repairing of a liquid crystal panel assembly according to an exemplary embodiment of the present invention.

FIG. 7b is a cross-sectional view of FIG. 7a taken along the line VIIb-VIIb.

FIG. 8 is an equivalent circuit diagram of two subpixels of a liquid crystal panel assembly according to another exemplary embodiment of the present invention.

FIG. 9 is an equivalent circuit diagram illustrating a pixel of a liquid crystal panel assembly according to another exemplary embodiment of the present invention.

FIG. 10 is a layout view of a liquid crystal panel assembly according to another exemplary embodiment of the present invention.

FIG. 11 is a cross-sectional view of the liquid crystal panel assembly of FIG. 10 taken along the line XI-XI.

FIG. 12 is an equivalent circuit diagram of a pixel of a liquid crystal panel assembly according to another exemplary embodiment of the present invention.

FIG. 13 is a layout view of a liquid crystal panel assembly according to another exemplary embodiment of the present invention..

FIG. 14 is an equivalent circuit diagram of a pixel of a liquid crystal panel assembly according to another exemplary embodiment of the present invention.

FIG. 15 is a layout view of a liquid crystal panel assembly according to another exemplary embodiment of the present invention.

FIG. 16 is a cross-sectional view of the liquid crystal panel assembly of FIG. 15 taken along the line XVI-XVI.

FIG. 17 is a block diagram illustrating a liquid crystal display according to another exemplary embodiment of the present invention.

FIG. 18 is a layout view of a liquid crystal panel assembly according to another exemplary embodiment of the present invention.

**DETAILED DESCRIPTION OF THE EMBODIMENTS**

The present invention will be described more fully hereinafter with reference to the accompanying drawings, in which exemplary embodiments of the invention are shown. As those skilled in the art would realize, the described embodiments may be modified in various different ways, all without departing from the spirit or scope of the present invention. In the drawings, the thickness of layers, films, panels, regions, etc., may be exaggerated for clarity. Like reference numerals designate like elements throughout the specification. It will be understood that when an element such as a layer, film, region, or substrate is referred to as being "on" another element, it can be directly on the other element or intervening elements may also be present. In contrast, when an element is referred to as being "directly on" another element, there are no intervening elements present.

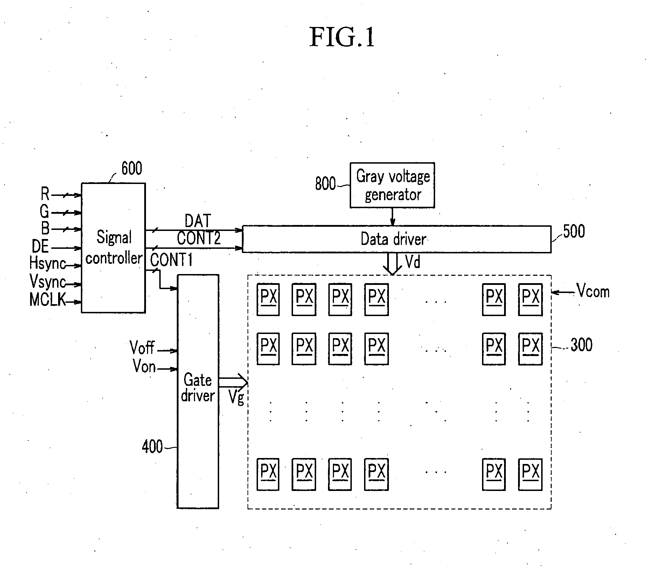

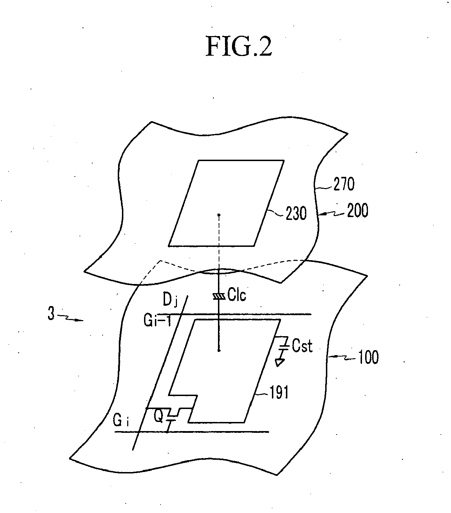

Hereinafter, a liquid crystal display according to an exemplary embodiment of the present invention will be described with reference to FIG. 1 and FIG. 2. FIG. 1 is a block diagram illustrating a liquid crystal display according to an exemplary embodiment of the present invention, and FIG. 2 is an equivalent circuit diagram illustrating a liquid crystal display device according to an exemplary embodiment of the present invention. As shown in FIG. 1, the liquid crystal display according to an exemplary embodiment of the present invention includes a liquid crystal panel assembly 300, gate drivers 400 and data drivers 500 connected thereto, a storage electrode driving unit 700, a gray voltage generator 800 connected to a data driver 500, and a signal controller 600 for controlling them.. The liquid crystal panel assembly 300 includes a plurality of signal lines (not shown) and a plurality of pixels PX connected to the signal lines and arranged in a matrix. In addition, the liquid crystal panel assembly 300 includes a lower panel 100, an upper panel 200 facing the lower panel, and a liquid crystal layer 3 interposed therebetween as shown in FIG. 2. The signal lines include a plurality of gate lines (not shown) transferring a gate signal (or a scanning signal), and a plurality of data lines (not shown) transferring a data signal. The gate lines basically extend in about a row direction in parallel with each other, and the data lines basically extend in about a column direction in parallel with each other.

Referring to FIG. 2, for example, a pixel PX connected to the i$^{th}$ gate line GL and the j$^{th}$ data line DL includes a switching element Q connected to the signal lines GL and DL, and a liquid crystal capacitor Clc and a storage capacitor Cst, which are connected to the switching element Q, where i=1, 2, ..., n and j=1, 2, ..., m. The storage capacitor Cst can be omitted according to need. The switching element Q is a three-terminal element such as a thin film transistor disposed at the lower panel 100. The switching element Q includes a control terminal connected to the gate line GL, an input terminal connected to a data line DL, and an output terminal connected to a liquid crystal capacitor Clc and a storage capacitor Cst.

The liquid crystal capacitor Clc uses a pixel electrode 191 at a lower panel 100 and a common electrode 270 of an upper panel 200 as two terminals, and a liquid crystal layer 3 between two electrodes 191 and 270 functions as a dielectric material. The pixel electrode 191 is connected to the switching element Q. The common electrode 270 is formed on the entire surface of the upper panel 200 and receives a common voltage Vcom. Unlike in FIG. 2, the common electrode 270 can be formed at the lower panel 100. In this case, at least one of the two electrodes 191 and 270 can be made in a line shape or a rod shape. A storage capacitor Cst functioning as a auxiliary of a liquid crystal capacitor Clc is formed of an additional storage electrode line (SL) overlapping with a pixel electrode 191 with an insulator interposed therebetween. A predetermined voltage such as a common voltage Vcom is applied to the additional signal line. The storage capacitor Cst can be formed of a pixel electrode 191 overlapping with a previous gate line with an insulator as a medium.

In order to provide a color display, each of the pixels PX displays unique one of primary colors (spatial division), or each of the pixels PX alternatively displays different primary colors according to a time (temporal division), thereby displaying desired colors through a spatial or temporal sum of these primary colors. For example, the primary colors are three primary colors of red, green and blue. FIG. 2 shows a color filter 230 displaying one of primary colors on a region of an upper panel 200 corresponding to a pixel electrode 191 by each of the pixels (PX1-PX3) as an example of spatial division. Unlike in FIG. 2, the color filter 230 can be formed above or under a pixel electrode 191 of the lower panel 100. At least one polarizer (not shown) is formed on the outer surface of the liquid crystal panel assembly 300.

Referring to FIG. 1 again, the gray voltage generator 800 generates a plurality of gray voltages or a reference gray voltage related to the transmittance of a pixel PX. The gate driver 400 supplies a gate signal Vg formed by combination of a gate-on voltage Von and a gate-off voltage Voff by being connected to a gate line of the liquid crystal panel assembly 300. The data driver 500 is connected to a data line of the liquid crystal panel assembly 300. The data driver 500 selects a gray voltage from the gray voltage generator 800 and supplies the selected gray voltage to a data line as a data signal. When the gray voltage generator 800 only provides a predetermined number of reference gray voltages instead of supplying gray voltages for all grays, the data driver 500 generates a gray voltage for all grays by dividing the reference gray voltage and selecting one therefrom. The signal controller 600 controls the gate driver 400 and the data driver 500.

Each of the drivers 400, 500, 600, and 800 can be mounted directly on a liquid crystal panel assembly 300 as at least one integrated circuit (IC) chip. They can also be attached on a liquid crystal panel assembly 300 as a TCP (tape carrier package) by being mounted on a flexible printed circuit film (not shown) or mounted on an additional printed circuit board (PCB). Conversely, the drivers 400, 500, 600, and 800 can be directly integrated with the liquid crystal panel assembly 300. The drivers 400, 500, 600, and 800 can also be integrated as a single chip. In this manner, at least one of the drivers or at least one circuit of circuits forming the drivers can be placed outside of the single chip.

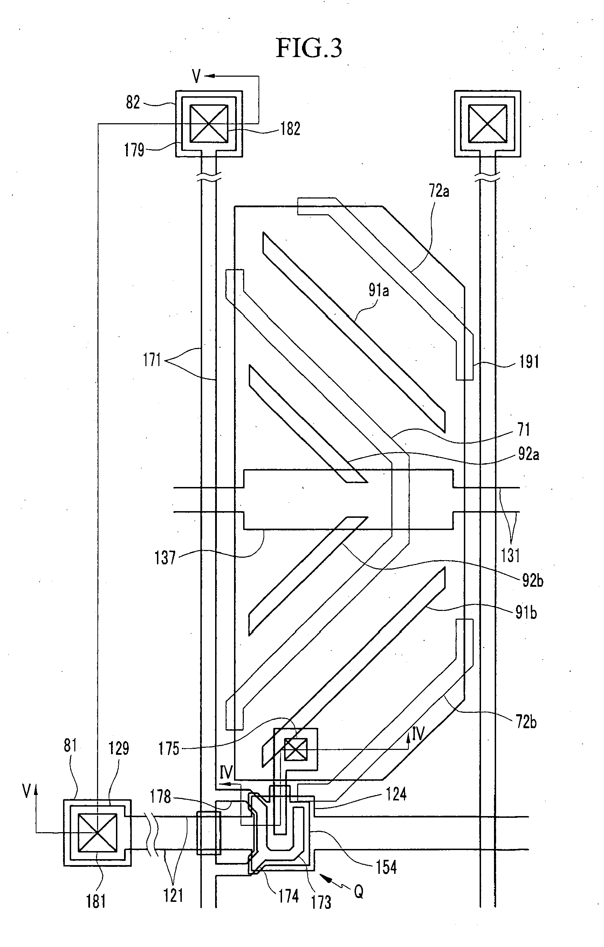

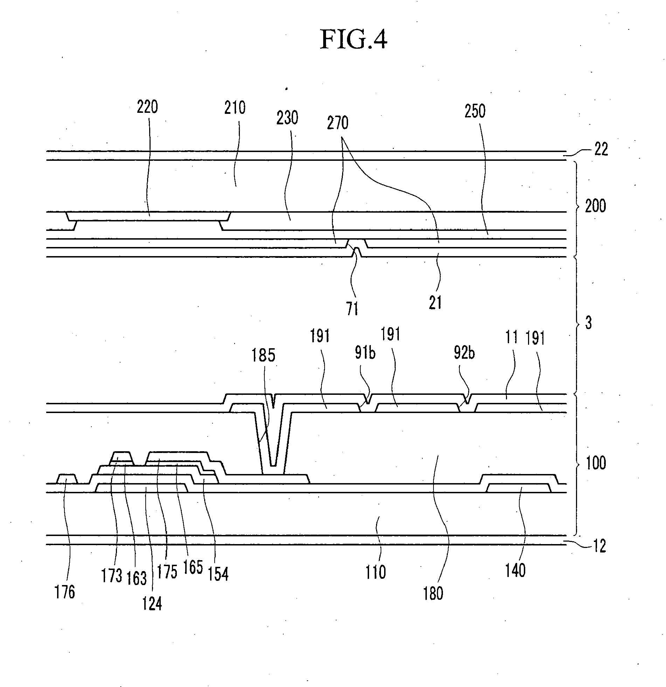

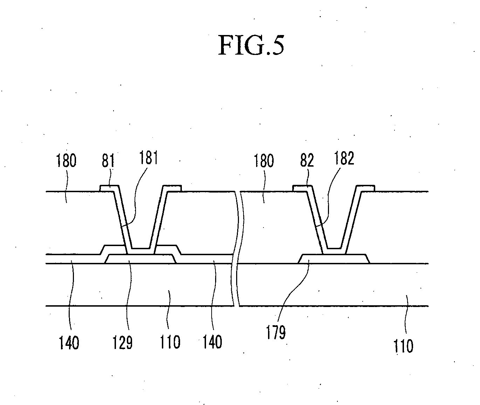

Hereinafter, a liquid crystal panel assembly according to an exemplary embodiment of the present invention will be described with reference to FIG. 3 to FIG. 5, and FIG. 1 and FIG. 2. FIG. 3 is a layout view of a liquid crystal panel assembly according to an exemplary embodiment of the present invention, and FIG. 4 and FIG. 5 are cross-sectional views of the liquid crystal panel assembly of FIG. 3 taken along the lines IV-IV and V-V.. Referring to FIGS. 3-5, the liquid crystal panel assembly according to the present exemplary embodiment includes a lower panel 100 and an upper panel 200 facing each other, and a liquid crystal layer 3 interposed between the panels 100 and 200.

First, the lower panel 100 will be described. A gate conductor having a plurality of gate lines 121 and a plurality of storage electrode lines 131 is formed on an insulation substrate 110 made of transparent glass or plastic. The gate lines 121 transfer a gate signal and extend in a substantially horizontal direction, as shown in FIG. 3. Each gate line 121 includes a plurality of gate electrodes 124 protruding upwardly and downwardly, and a wider end contact portion 129 for contacting to other layers or an external driving circuit. A gate driving circuit (not shown) for generating a gate signal can be mounted on a flexible printed, circuit film (not shown) attached on the substrate 110, directly mounted on the substrate 110, or integrated with the substrate 110. When the gate driving circuit is integrated with the substrate 110, the gate driving circuit can be directed connected to the extended gate lines 121. Each storage electrode line 131 receives a predetermined voltage and includes a plurality of storage electrode extensions 137 protruding upwardly and downwardly. However, the storage electrode lines 131 can vary in a shape and arrangement.

The gate conductors 121 and 131 can be made of an aluminum group metal such as aluminum (Al) and an aluminum alloy, a silver group metal such as silver (Ag) and a silver alloy, a copper group metal such as copper (Cu) and a copper alloy, a molybdenum group metal such as molybdenum (Mo) and a molybdenum alloy, chromium (Cr), tantalum (Ta, or titanium (Ti). However, they can have a multi-layered structure having two conductive layers (not shown) with different physical properties. A conductive layer among them can be made of a metal having low resistivity, for example an aluminum group metal, a silver group metal, and a copper group metal in order to reduce signal delay or voltage drop. Conversely, the other conductive layer can be made of a different material having excellent physical, chemical, and electrical contact characteristics similar to ITO (indium tin oxide) and IZO (indium zinc oxide), for example a molybdenum group metal, chromium, tantalum, or titanium. For example, such a structure can have a chromium lower layer and an aluminum (alloy) upper layer, or an aluminum (alloy) lower layer and a molybdenum (alloy) upper layer. However, the gate conductors 121 and 131 can be made of various metals or conductors besides the materials described above. It is desirable that the sides of the gate conductors 121 and 131 are inclined to the substrate 110, and the inclination angles thereof are in a range of about 30° to about 80°.

A gate insulating layer 140 made of silicon nitride (SiNx) or silicon oxide (SiOx) is formed on the gate conductors. A plurality of semiconductor islands 154 made of hydrogenated amorphous silicon (a-Si) or polysilicon are formed on the gate insulating layer 140. Each semiconductor island 154 is placed on a gate electrode 124. A plurality of ohmic contact islands (ohmic contacts) 163 and 165 are formed on the semiconductor 154. The ohmic contacts 163 and 165 are made of n+ hydrogenated amorphous silicon doped with a highly concentrated n-type impurity such as phosphor, or they may be made of silicide. The sides of the semiconductors 154 and the ohmic contacts 163 and 165 are also inclined to the substrate 110, and the inclination angles therebetween are in a range of about 30° to about 80°.

A plurality of data lines 171, a plurality of drain electrodes 175, and a plurality of storage electrode lines 131 are formed on the ohmic contacts 163 and 165 and the gate insulating layer 140. The data lines 171 transfer a data signal and extend in a substantially vertical direction, thereby intersecting with the gate lines 121 and the storage electrode lines 131. Each data line 171 includes a plurality of source electrodes 173 bent in a U shape by extending toward the gate electrode 124, and a wider end contact portion 179 for contacting other layers or the data driver 500. In the case that the data driver 500 is directly integrated with the substrate 110, the data driver 500 can be directly connected to the extended data lines 171.

The data lines 171 and source electrodes 173 are connected through first and second interconnectors 174 and 178, or junctions 174 and 178, comprising electrical conductors or wires configured to connect data lines 171 and source electrodes 173. In this manner, a plurality of interconnectors (two or more) may be used to connect the data lines 171 with the source electrodes 173. The first and second interconnectors 174 and 178 are symmetrically disposed to face each other with the gate line 121 interposed therebetween, and the first and second interconnectors 174 and 178 do not overlap with the gate line 121. The drain electrodes 175 are separated from the data lines 171 and face the source electrodes 173 disposed on the gate electrodes 124. Each drain electrode 175 includes one end having a wider end area, and another end formed in a rod shape and having a predetermined area surrounded by the source electrode 173. One gate electrode 124, one source electrode 173, and one drain electrode 175 form a thin film transistor TFT with a semiconductor 154, and the channel of the thin film transistor is formed between the source electrode 173 and the drain electrode 175 on the semiconductor 154.

The data conductors 171 and 175 are made of a refractory metal such as molybdenum, chromium, tantalum, titanium, and an alloy thereof, and have a multi-layered structure made of a refractory metal layer (not shown) and a low-resistivity conductive layer (not shown). For example, the multi-layered structure may be a dual-layered structure made of a chromium or molybdenum (alloy) lower layer and an aluminum (alloy) upper layer, or a triple-layered structure made of a molybdenum (alloy) lower layer, an aluminum (alloy) middle layer, and a molybdenum (alloy) upper layer. However, the data lines 171, the drain electrodes 175, and the storage electrode lines 131 can be made of various metals or conductors besides the materials described above. It is desirable that the data conductors 171 and 175 are also inclined to the substrate 110, and the inclination angle is in a range of about 30° to about 80°. The ohmic contacts 163 and 165 are only present between the semiconductors 154 disposed thereunder and the data conductors 171 and 175 disposed thereabove. The ohmic contacts 163 and 165 reduce the contact resistance therebetween. Each semiconductor 154 includes an exposed region that is not covered by a data line 171 and a drain electrode 175, such as a region between the source electrode 173 and the drain electrode 175.

A passivation layer 180 is formed on the data conductors 171 and 175 and the exposed portion of the semiconductors 154. The passivation layer 180 can be made of an inorganic insulator or an organic insulator, and can have a flat top surface. It is desirable that the organic insulator has a dielectric constant of less than about 4.0 and photosensitivity. The passivation layer 180 can have a dual-layered structure made of a lower inorganic layer and an upper organic layer at the exposed region of the semiconductor 154 in order to sustain the inorganic layer's excellent insulating characteristic and to not damage the exposed region of the semiconductor 154. A plurality of contact holes 182 and 185 are formed in the passivation layer 180 to expose the ends 179 of the data lines 171 and the drain electrodes 175, and a plurality of contact holes 181 are formed at the passivation layer 180 and the gate insulating layer 140 to expose the ends 129 of the gate lines 121. A plurality of pixel electrodes 191 and a plurality of contact assistants 81 and 82 are formed on the passivation layer 180. They can be made of a transparent conductive material such as ITO or IZO, or a reflective metal such as aluminum, silver, chromium, or an alloy thereof.

Each pixel electrode 191 is physically and electrically connected to a drain electrode 175 through a contact hole 185, and receives a data voltage from the drain electrode 175. The pixel electrode 191 receiving the data voltage induces an electric field with the common electrode 270 of the common electrode panel 200. Therefore, the orientation of the liquid crystal molecules of the liquid crystal layer 3 between the two electrodes 191 and 270 is determined. The polarization of the light passing through the liquid crystal layer 3 varies according to the determined orientation of the liquid crystal molecules. The pixel electrode 191 and common electrode 270 sustain the supplied voltage after a thin film transistor is turned off by forming a capacitor (hereinafter, liquid crystal capacitor). The pixel electrode 191 overlaps with the storage electrode line 131 such as storage electrodes 137a and 137b, thereby forming a storage capacitor that enhances the voltage sustain capability of the liquid crystal capacitor.

Each pixel electrode 191 also has a quadrangle shape having two pairs of main sides formed about parallel with the gate lines 121 or the data lines 171. Each pixel electrode 191 has a chamfered right corner, thereby forming an oblique side, and the oblique side forms an angle of about 45° with the gate line. The pixel electrode 191 includes a first upper cutout 91a, a first lower cutout 91b, a second upper cutout 92a, and a second lower cutout 92b, and the pixel electrode 191 partitions a plurality of regions by these cutouts 91a, 91b, 92a, and 92b. The cutouts 91a; 91b, 92a, and 92b are disposed with approximately inverse symmetry with respect to a storage electrode line 131 bisecting the pixel electrode 191. The cutouts 91a, 91b, 92a, and 92b obliquely extend about from the right side to the left side of the pixel electrode 191. The first and second upper cutouts 91a and 92a and the first and second lower cutouts 91b and 92b are placed on an upper area and a lower area based on the storage electrode line 131, respectively. The first and second upper cutouts 91a and 92a and the first and second lower cutouts 91b and 92b extend vertical to each other to form an angle of about 45° with the gate line 121. Therefore, the lower area of the pixel electrode 191 is divided into three regions by the first and second lower cutouts 91b and 92b, and the upper area thereof is divided into three regions by the first and second upper cutouts 91a and 92a. The number of regions or cutouts can change depending on design elements such as the size of the pixel electrode 191, the length ratio between the vertical side and the horizontal side of the pixel electrode 191, and the type or characteristics of liquid crystal layer 3. The contact assistants 81 and 82 are connected to the ends 129 of the gate lines 121 and the ends 179 of the data lines 171 through corresponding contact holes 181 and 182. The contact assistants 81 and 82 complement the adhesive property between an external device and the ends 129 of the gate lines 121 or the ends 179 of the data lines 171, and protect them.

Hereinafter, the upper panel 200 will be described. A light blocking member 220 is formed on an insulation substrate 210 made of transparent glass or plastic. The light blocking member 220 is also called a black matrix and blocks light leaking from between the pixel electrodes 191. The light blocking member 220 includes a linear area corresponding to the data lines 171 and a planar area corresponding to the thin film transistors. The light blocking member 220 prevents light leakage between the pixel electrodes 191 and defines an opening region facing the pixel electrodes 191. The light blocking member 220 can have a plurality of openings (not shown) facing the pixel electrodes 191 and having about the same shape as the pixel electrodes 191. A plurality of color filters 230 are formed on the substrate 210. Generally, the color filters 230 are formed in a region surrounded by the light blocking member 220, and extend lengthwise along the line of pixel electrodes 191. Each of the color filters 230 can display one of three primary colors of red, green, and blue.

An overcoat 250 is formed on the color filters 230 and the light blocking member 220. The overcoat 250 can be made of an organic insulator. Such an overcoat 250 prevents the color filters 230 from being exposed and provides a flat surface. The overcoat 250 can be omitted. However, when present, a common electrode 270 is formed on the overcoat 250. The common electrode 270 can be made of a transparent conductor such as ITO and IZO. In the common electrode 270, a plurality of cutouts 71, 72a, and 72b are formed. One of cutout sets 71 to 72b faces one pixel electrode 191, and includes a center cutout 71, a lower cutout 72a, and an upper cutout 72b. Each of the cutouts 71-72b is disposed between cutouts 91 to 92b adjacent to the pixel electrode 191, cutouts 92a and 92b, or the chamfered oblique sides 90a and 90b of the pixel electrode 191. Each of the cutouts 71 to 72b includes at least one of oblique line units extending in parallel with the lower cutout 92a and the upper cutout 92b of the pixel electrode 191. The cutouts 71 to 72b are disposed with approximately inverse symmetry with respect to the storage electrode line 131.

Each of the lower and upper cutouts 72a and 72b has an oblique line part, a horizon line part, and a vertical line part. The oblique line part extends about from the upper area or the lower area of the pixel electrode 191 to the right side or the left side of the pixel electrode 191. The horizontal line part and the vertical line part extend from each end of the oblique line part along the side of the pixel electrode 191 while overlapping with the side of the pixel electrode 191. The horizontal line part and the vertical line part form an obtuse angle with the oblique line part. The cutout 71 has a center vertical line part, a pair of oblique line parts, and a pair of end vertical line parts. The center vertical line part vertically extends from about the left side of the pixel electrode 191 to the storage electrode line 131. The pair of oblique line parts extends from the end of the center vertical line part to the right side of the pixel electrode 191, thereby forming an obtuse angle with the center vertical line part, and extends in parallel with the lower and upper cutouts 72a and 72b, respectively. The end vertical line part extends from the end of a corresponding oblique line part to the right side of the pixel electrode while overlapping with the right side, thereby forming an obtuse angle with the oblique line part. The number of cutouts 71 to 72b can change depending on design elements, and the light blocking member 220 can overlap with the cutouts 71 to 72b, thereby blocking light leakage around the cutouts 71 to 72b. At least one of cutouts 71 to 72b, 91a, 91b, 92a, and 92b can be replaced with a protrusion (not shown) or depression (not shown). The protrusion can be made of an organic material or an inorganic material, and can be disposed on or under a field generating electrode 191.

Alignment layers 11 and 21 are coated on the inside surfaces of the display panels 100 and 200, and they can be vertical alignment layers. Polarizers 12 and 22 are provided at the outer surface of the display panels 100 and 200, and the polarization axis of the two polarizers can be in parallel with or cross each other. It is desirable that one of the polarization axes is in parallel with the gate lines 121 a and 121 b. In the case of a reflective liquid crystal display, one of the two polarizers 12 and 22 can be omitted. The liquid crystal display also can include polarizers 12 and 22, a phase retardation film, display panels 100 and 200, and a lighting unit for providing light to a liquid crystal layer 3. The liquid crystal layer 3 has positive or negative dielectric anisotropy, and the liquid crystal molecules of the liquid crystal layer 3 are arranged to have longitudinal axes vertical to the surface of the two display panels in a state of no electric field.

Hereinafter, a method of operation of a liquid crystal display according to the present embodiment will be described in detail. A signal controller 600 receives input image signals R, G, and B and an input control signal for displaying the received input image signals R, G, and B from an external graphics controller (not shown). The input image signals R, G, and B contain information about luminance of each pixel PX, and the luminance has a predetermined number of grays, for example 1024 ($=2^{10}$), 256 ($=2^8$), or 64 ($=2^6$). For example, the input control signal includes a vertical synchronization signal Vsync, a horizontal synchronizing signal Hsync, a main clock signals MCLK, and a data enable signal DE. The signal controller 600 processes the input image signals R, G, and B to be appropriate for the operating conditions of the liquid crystal panel assembly 300 and the data driver 500 based on the input image signals R, G, and B and input control signal, and generates a gate control signal CONT1 and a data control signal CONT2. Then, the signal controller 600 outputs the gate control signal CONT1 to the gate driver 400 and outputs the data control signal CONT2 and the processed image signal DAT to the data driver 500. The output image signal DAT is a digital signal, and has a predetermined number value or a predetermined gray.

The gate control signal CONT1 includes a scanning start signal STV for ordering starting of scanning and at least one clock signal for controlling the output cycle of the gate- on voltage Von. The gate control signal CONT1 can further include an output enable signal OE that limits a time duration of the gate-on voltage Von. The data control signal CONT2 includes a horizontal synchronization start signal STH for notifying beginning of transmitting image signals for a set of sub-pixels, and a load signal LOAD and a data clock signal HCLK for ordering to supply a data signal to the liquid crystal panel assembly. The data control signal CONT2 can further include an inversion signal RVS that inverts a voltage polarity of a data signal for a common voltage Vcom. Hereinafter, a data signal polarity denotes the voltage polarity of a data signal for a common voltage.

The data driver 500 receives a digital image signal DAT for a set of sub-pixels, and converts the digital image signal DAT to an analog data signal by selecting a gray voltage corresponding to each digital image signal DAT according to the data control signal CONT2 from the signal controller 600. Then, the analog data signal is supplied to a corresponding data line. The gate driver 400 supplies a gate-on voltage Von to the gate line according to a gate control signal CONT1 from the signal controller 600, thereby turning on a switching element connected to the gate line. Then, the data signal supplied to the data line is supplied to a corresponding pixel PX through the turned-on switching element.

The gate driver 400 supplies a gate-on voltage Von to the gate line according to a gate control signal CONT1 from the signal controller 600, thereby turning on a switching element connected to the gate line. Then, the data signal supplied to the data line is supplied to a corresponding pixel through the turned-on switching element. By repeating the above described operation in a unit of 1 horizontal period 1H that is equivalent to one cycle of a horizontal synchronizing signal Hsync and a data enable signal DE, the data signal is provided to all pixels PX, thereby displaying an image of a frame. After displaying the image of one frame, the next frame starts and the state of the inversion signal RVS supplied to the data driver 500 is controlled to invert the polarity of the data signal from the previous frame ("frame inversion"). Herein, the polarity of a data signal flowing through a data line can be inverted according to characteristics of the inversion signal RVS even within one frame (for example: row inversion, dot inversion), or the polarity of the data signal supplied to one pixel can be different (for example: column inversion, dot inversion).

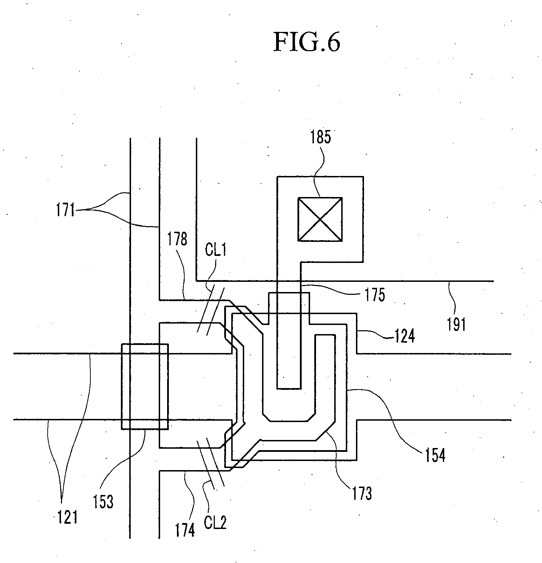

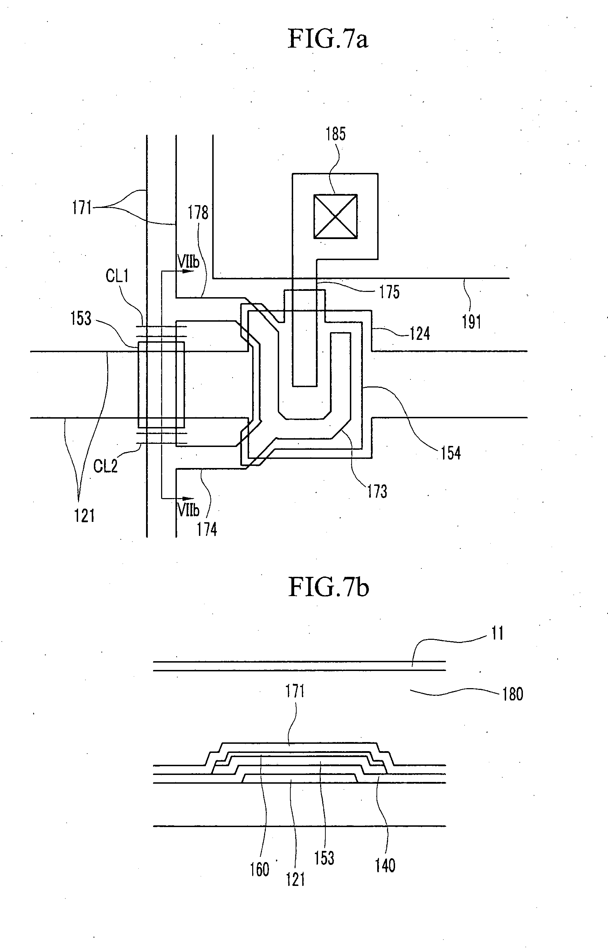

Hereinafter, a method of repairing a liquid crystal display according to an exemplary embodiment of the present invention will be described with reference to FIG. 4 and FIGS. 6-7b. FIG. 6 and FIG. 7a show the repairing of a liquid crystal panel assembly according to an exemplary embodiment of the present invention, and FIG. 7b is a cross-sectional view of FIG. 7a taken along the line VIIb-VIIb. Referring to FIG. 4, in the cross-section view thereof, a gate electrode 124, a source electrode 173, and a drain electrode 175 forming a thin film transistor disposed to face one another with a gate insulating layer 140, a semiconductor layer 154, and ohmic contacts 163 and 165 interposed therebetween. Since the gate insulating layer 140, the semiconductor layer 154, and the ohmic contacts 163 and 165 are all thin films, the gate electrode 124, the source electrode 173, and the drain electrode 175 can become shorted due to errors or defects introduced in a manufacturing process. If they are shorted, a corresponding thin film transistor cannot operate normally, and a corresponding pixel can become deteriorated so that it cannot perform a normal display operation in a liquid crystal display. In this case, the data line 171 is physically and electrically separated from the source electrode 173 by cutting or severing the first and second interconnectors 174 and 178 that connect the data line 171 and the source electrode 173, using a laser so that the data voltage flowing in the data line 171 cannot be supplied to the source electrode 173, thereby preventing undesired operation of the deteriorated thin film transistor. A pixel electrode 191 that is transitioned into a floating state by cutting the first and second interconnectors 174 and 178 is shorted to a storage electrode line 131 using a laser according to the first and second cut lines CL1 and CL2. In this manner, a common voltage Vcom flowing in the storage electrode line 131 1 is continuously applied to the pixel electrode 191 in order to maintain the pixel electrode 191 in a black or inactive state. Therefore, the deteriorated pixel can be excluded from the display operation in the liquid crystal panel.

Referring to FIG. 7a and FIG. 7b, a semiconductor bit 153 is formed at the crossing point of the data line 171 and the gate line 121. The semiconductor bit 153 prevents the data line 171 from being shorted by smoothing the profile of the surface. Since the gate insulating layer 140, the semiconductor bit 153, and the ohmic contact 160 are stacked between the gate line 121 and the data line 171 in this area, the gate line 121 is insulated from the data line 171. However, the gate line 121 and the data line 171 can be shorted because the gate insulating layer 140, the semiconductor bit 153, and the ohmic contact 160 are all thin films. In this case, two areas of the data line 171 are cut to separate the crossing point of the gate line 121 and the data line 171 from the data line 171 as shown in FIG. 7a. The first and second cut lines CL1 and CL2 of the data line 171 are between the first and second interconnectors 174 and 178. Then, the data voltage flowing along the data line 171 placed above the first cut line CL1 flows along the data line 171 under the second cut line CL2 through the second interconnector 178, the source electrode 173, and the first interconnector 174 instead of the crossing of the data line 171 and the gate line 121. Therefore, the data voltage can be smoothly transferred without being influenced by the short between the data line 171 and the gate line 121. As described above, the liquid crystal display according to an exemplary embodiment of the present invention can be repaired not only when the gate electrode 124, the source electrode 173, and the drain electrode 175 forming the thin film transistor are shorted, but also when the data line 171 and the gate line 121 are shorted.

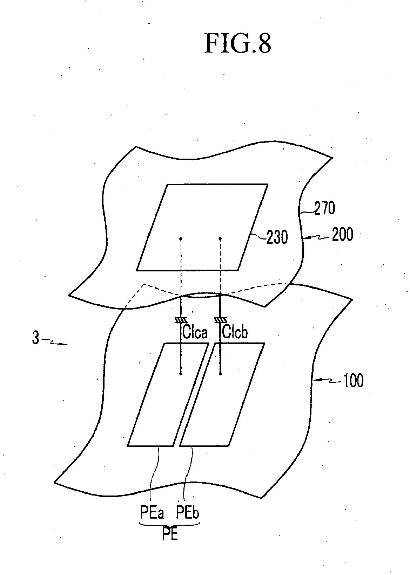

Hereinafter, a liquid crystal panel assembly according to another exemplary embodiment of the present invention will be described with reference to FIG. 8 to FIG. 11. FIG. 8 is an equivalent circuit diagram of two sub-pixels of a liquid crystal panel assembly according to another exemplary embodiment of the present invention. Referring to FIG. 8, each pixel PX includes a pair of sub-pixels, and the sub-pixels respectively include liquid crystal capacitors Clca and Clcb. At least one of the two sub-pixels includes a switching element (not shown) connected to a gate line, a data line, and a liquid crystal capacitor Clca or and Clcb. The liquid crystal capacitor Clca or Clcb includes the sub-pixel electrode PEa or PEb of the lower panel 100 and the common electrode 270 of the upper panel 200 as two terminals, and a liquid crystal layer 3 between the sub-pixel electrode PEa or PEb and the common electrode 270 functions as a dielectric material. A pair of sub-pixel electrodes PEa and PEb that are separate from each other forms a pixel electrode PE. The common electrode 270 is formed on the entire surface of the upper panel 200 and receives a common voltage Vcom. The liquid crystal layer 3 has negative dielectric anisotropy, and the liquid crystal molecules of the liquid crystal layer 3 can be arranged to have a longitudinal axis vertical to the surface of the two display panels in a state of no electric field. Since a color filter 230 and a polarizer (not shown) were already described above, descriptions thereof are omitted.

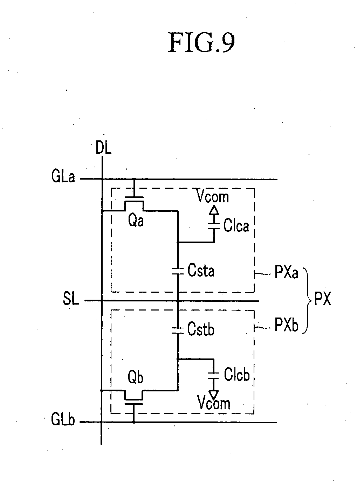

Hereinafter, a liquid crystal panel assembly according to another exemplary embodiment of the present invention will be described with reference to FIG. 1 and 8-11. FIG. 9 is an equivalent circuit diagram illustrating a pixel of a liquid crystal panel assembly according to another exemplary embodiment of the present invention. Referring to FIG. 9, the liquid crystal panel assembly according to the present exemplary embodiment includes signal lines having a pair of gate lines GLa and GLb, a plurality of data lines DL and a plurality of storage electrode lines SL, and a plurality of pixels PX connected to the signal lines. Each of pixels PX includes a pair of sub-pixels PXa and PXb. Each of the sub-pixels PXa and PXb includes a switching element Qa or Qb connected to a corresponding gate line GLa or GLb and a data line DL, a liquid crystal capacitor Clca or Clcb connected thereto, and a storage capacitor Csta or Cstb connected to the switching element Qa or Qb and the storage electrode line SL. Each of the switching elements Qa and Qb is a three-terminal element such as thin film transistor, disposed at the lower panel 100. Each of the switching elements Qa and Qb includes a control terminal connected to the gate line GLa or GLb, an input terminal connected to a data line DL, and an output terminal connected to a liquid crystal capacitor Clca or Clcb and a storage capacitor Csta or Cstb.

A storage capacitor Csta and Cstb functioning as an auxiliary of a liquid crystal capacitor Clca and Clcb is formed of a storage electrode line SL overlapping with a pixel electrode PE with an insulator interposed therebetween. A predetermined voltage such as a common voltage Vcom is applied to the storage electrode line SL. The storage capacitor Csta and Cstb can be formed of a sub-pixel electrode PEa and PEb overlapping with a previous gate line with an insulator as a medium. Since the liquid crystal capacitors Clca and Clcb were already described above, further detailed description thereof will be omitted.

As described above, in the liquid crystal display including the liquid crystal panel assembly, a signal controller 600 can receive an input image signal R, G, and B for one pixel, convert the received input image signal to an output image signal DAT for two sub-pixels PXa and PXb, and transmit the output image signal DAT to a data driver 500. On the other hand, a gray voltage generator 800 independently generates gray voltage sets for two sub-pixels PXa and PXb and alternatively provides the generated gray voltage sets to the data driver 500, or the data driver 500 alternatively selects the gray voltage sets so as to supply different voltages to two sub-pixels PXa and PXb. It is desirable that an image signal is corrected or a gray voltage set is generated to have a composite gamma curve of two sub-pixels PXa and PXb to be close to a reference gamma curve in the front. For example, a front composite gamma curve must be matched with a front reference gamma curve that is set to be most suitable for the liquid crystal panel assembly, and the side composite gamma curve must be closest to the front reference gamma curve.

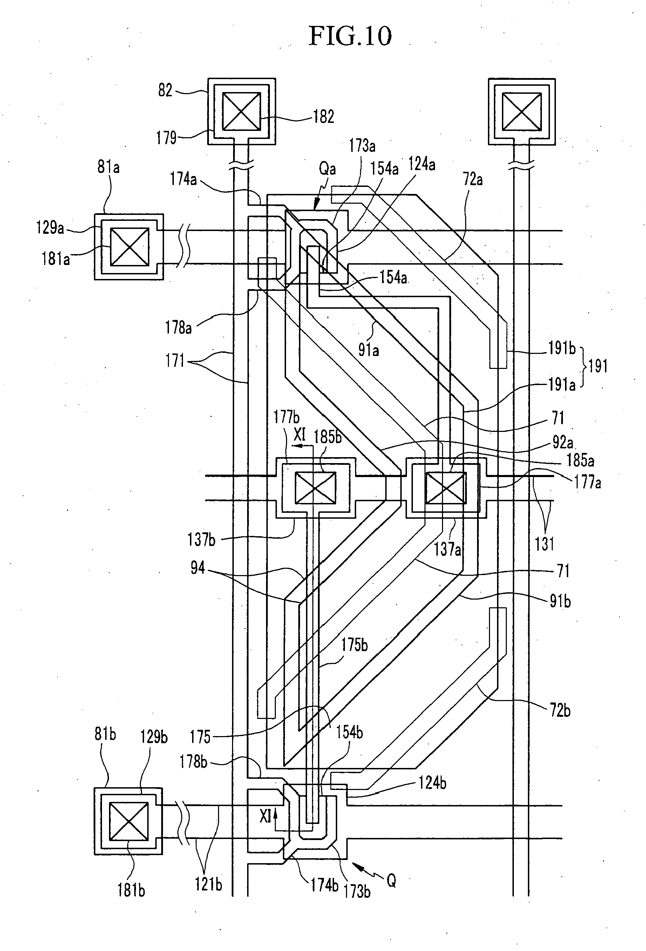

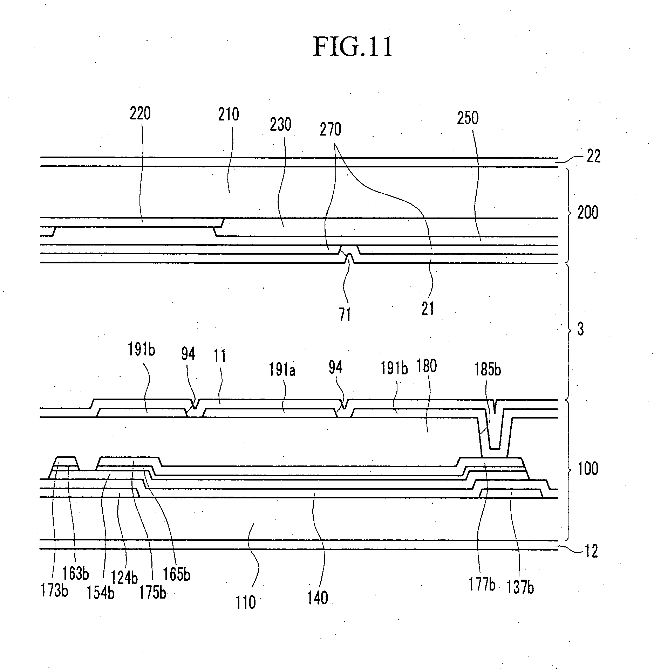

Hereinafter, the liquid crystal panel assembly according to an exemplary embodiment of the present invention shown in FIG. 9 will be described with reference to FIGS. 10-11. FIG. 10 is a layout view of a liquid crystal panel assembly according to another exemplary embodiment of the present invention, and FIG. 11 is a cross-sectional view of the liquid crystal panel assembly of FIG.

10 taken along the line XI-XI. Referring to FIGS. 10-11, the liquid crystal panel assembly according to the exemplary embodiment includes a lower panel 100 and an upper panel 200 facing each other, and a liquid crystal layer 3 interposed therebetween. The layered structured of the liquid crystal panel assembly according to the present exemplary embodiment is identical to that of the liquid crystal display panel shown in FIG. 3 to FIG. 5.

Referring to FIGS. 10-11, the lower panel will now be described. A plurality of gate conductors having a plurality of pairs of first and second gate lines 121a and 121b, and a storage electrode line 131 are formed on an insulation substrate 110. Each of the gate lines 121a and 121 b includes an end portion 129a or 129b of the first and second gate electrodes 124a and 124b. A storage electrode line 131 includes storage electrodes 137a and 137b. A gate insulating layer 140 is formed on the gate conductors 121a, 121b, and 131. Semiconductor islands 154a and 154b are formed on the gate insulating layer 140, and a plurality of ohmic contacts 163a and 165a are formed thereon. A data conductor having a plurality of data lines 171 and a plurality of pairs of first and second drain electrodes 175a and 175b are formed on the ohmic contacts 163a and 165a and the gate insulating layer 140. Each data line 171 includes a plurality of pairs of first and second source electrode 173a and 173b and the end portion 179. The first and second source electrodes 173a and 173b are connected to the data line 171 through the first and second interconnectors 174a, 174b, 178a, and 178b. A passivation layer 180 is formed on the data conductors 171, 175a, and 175b and the exposed portion of the semiconductors 154a and 154b. A plurality of contact holes 181a, 181b, 182, 185a; and 185b are formed on the passivation layer 180 and the gate insulating layer 140. A plurality of pixel electrodes 191 and a plurality of contact assistants 81 a, 81 b, and 82 are formed on the passivation layer 180. An alignment layer 11 is formed on the pixel electrodes 191, the contact assistants 81a, 81b, and 82, and the passivation layer 180.

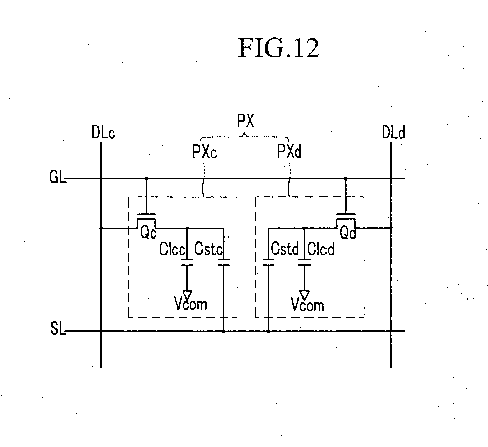

Hereinafter, the upper panel of the liquid crystal panel assembly according to the exemplary embodiment shown in FIGS. 12-13 will be described. A light blocking member 220, an overcoat 250, a common electrode 270, and an alignment layer 21 are formed on an insulation substrate 210. Unlike the liquid crystal panel assembly shown in FIG. 3 and FIG. 5, the liquid crystal panel assembly according to the exemplary embodiment shown in FIGS. 10-11 includes the first and second sub-pixel electrodes 191a and 191b where a pixel electrode 191 is separated. The first and second sub-pixel electrodes 191a and 191b are separated from each other by a gap 94. The gap 94 includes an oblique line part, and the oblique line part forms an angle of 45° with the gate line 121. Different data voltages set for one input image signal are supplied to a pair of sub-pixel electrodes 191 a and 191b. The amplitude thereof can be set according to the size and shape of the sub-pixel electrodes 191 a and 191 b. The areas of the sub-pixel electrodes 191 a and 191 b can be different. For example, the second sub-pixel electrode 191b receives a higher voltage compared to the first sub-pixel electrode 191 a, and has a larger area compared to the first sub-pixel electrode 191a.

An angle of tilting the liquid crystal molecules changes according to the magnitude of the electric field. Since the voltages of two liquid crystal capacitors Clca and Clcb are different from each other, the angles of tilting of the liquid crystal molecules become different. Therefore, the luminances of the two sub-pixels are different. Therefore, if the voltage of the first liquid crystal capacitor Clca is controlled to be matched with the voltage of the second liquid crystal capacitor Clcb, it is possible to most closely match an image watched from the side to an image watched from the front. That is, the side gamma curve can be most closely matched to the front gamma curve, thereby improving side visibility.

Also, the side gamma curve can be controlled to be further closer to the front gamma curve by reducing the area of the first sub-pixel electrode 191 a receiving the high voltage to be smaller than the area of the second sub-pixel electrode 191b. Particularly, when the area ratio of the first and second sub-pixel electrodes 191a and 191b is about 1:2 to about 1:3, the side gamma curve becomes even closer to the front gamma curve, thereby improving the side visibility. The direction of the secondary electric field additionally generated by the voltage difference between the sub-pixel electrodes 191a and 191b is vertical to the main side of a subregion. Therefore, the direction of the secondary electric field is matched with the direction of the horizontal component of the primary electric field. Finally, the secondary electric field between the sub-pixel electrodes 191 a and 191b strengthens the crystals of the liquid crystal molecules in the tilting direction.

Unlike the liquid crystal panel assembly shown in FIG. 3 and FIG. 5, the liquid crystal panel assembly according to the exemplary embodiment shown in FIG. 10 and FIG. 11 includes two gate lines 121a and 121 b, gate electrodes 124a and 124b, semiconductor islands 154a and 154b, source electrodes 173a and 173b, and drain electrodes 175a and 175b. The first and second gate electrodes 124a and 124b, the first and second source electrodes 173a and 173b, and the first and second drain electrodes 175a and 175b form a first and a second thin film transistor (TFT) Qa and Qb with the first and second semiconductors 154a and 154b. The channels of the first and second thin film transistors Qa and Qb are formed between the first and second source electrodes 173a and 173b, and the first and second drain electrodes 175a and 175b on the first and second semiconductors 154a and 154b, respectively. Furthermore, the semiconductors 154a and 154b extend along the data line 171 and the drain electrodes 175a and 175b, thereby forming a semiconductor stripe 151, and an ohmic contact 163b extends along the data line 171, thereby forming an ohmic contact stripe 161. The semiconductor stripe 151 has a plane shape substantially identical to that of the data line 171, the drain electrodes 175a and 175b, and the bottom of the ohmic contacts 161 and 165b.

In a method of manufacturing the thin film transistor array panel according to an exemplary embodiment of the present invention, the data lines 171, the drain electrodes 175a and 175b, the semiconductors 151, and the ohmic contacts 161 and 165b are formed in a single photolithography process. A photosensitive film having regions with difference thicknesses is used in the photolithography process. Particularly, the photosensitive film sequentially includes a first region, and a second region that is thinner than the first region. The first region is placed at a wiring region occupied by the data line 171 and the drain electrodes 175a and 175b, and the second region is placed at the channel region of the thin film transistor.

As a photosensitive film having regions with different thicknesses, a photomask having a light transmitting area, a light blocking area, and a translucent area can be used. At the translucent area, a thin film having a slit pattern, a lattice pattern, an intermediate light transmitting rate, or an intermediate thickness is disposed. When a thin film with a slit pattern is disposed, it is desirable that the width of the slit or the gap between slits is smaller than a resolution of a light exposer used in a photolithography process. As another example, a reflowable photosensitive film can be used. That is, the reflowable photosensitive film is formed using a typical photosensitive film having only a light transmitting area and a light blocking area. Then, a thinner region thereof is formed by reflowing the formed photosensitive film to a region where no photosensitive film remained. As described above, the manufacturing method thereof can be simplified by reducing the photolithography processes. Numerous advantages of the liquid crystal panel assembly shown in FIG. 3 to FIG. 5 can be applied identically to the liquid crystal panel assembly shown in FIG. 10 and FIG. 11.

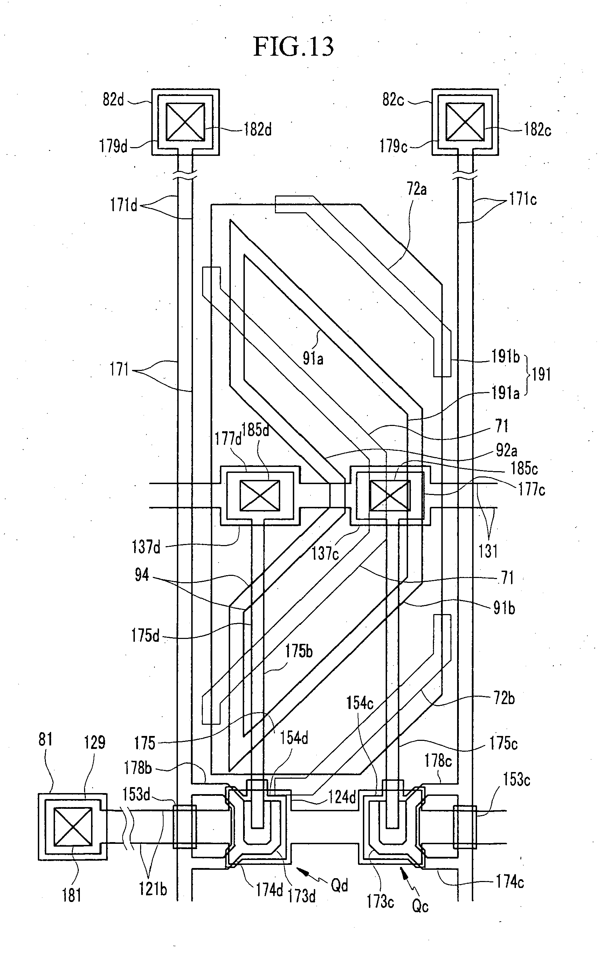

Hereinafter, the liquid crystal panel assembly according to another exemplary embodiment of the present invention shown in FIG. 8 will be described with reference to FIG. 12 and FIG. 13. FIG. 12 is an equivalent circuit diagram of a pixel of a liquid crystal panel assembly according to another exemplary embodiment of the present invention. Referring to FIG. 12, the liquid crystal panel assembly according to the present exemplary embodiment includes signal lines having a plurality of gate lines GL, a plurality of pairs of data lines DLc and DLd, and a plurality of storage electrode lines SL, and a plurality of pixels PX connected to the signal lines. Each of pixels PX includes a pair of sub-pixels PXc and PXd. Each of the sub-pixels PXc and PXd includes a switching element Qc or Qd connected to a corresponding gate line GL and data lines DLc and DLd, a liquid crystal capacitor Clcc or Clcd connected thereto, and a storage capacitor Cstc or Cstd connected to the switching element Qc or Qd and the storage electrode line SL. Each of the switching elements Qc and Qd is a three-terminal element such as a thin film transistor disposed at the lower panel 100. Each of the switching elements Qc and Qd includes a control terminal connected to the gate line GL, an input terminal connected to the data lines DLc and DLd, and an output terminal connected to a liquid crystal capacitor Clcc or Clcd and a storage capacitor Cstc or Cstd. Since the operations of the liquid crystal capacitors Clcc and Clcd, the storage capacitors Cstc and Cstd, and the liquid crystal display having the liquid crystal panel assembly are substantially identical to those of the above described exemplary embodiment, a detailed description thereof will be omitted. Although two sub-pixels PXa and PXa forming one pixel PX receive a data voltage with a predetermined disparity in the liquid crystal panel assembly shown in FIG. 9, the two sub-pixels PXc and PXd receive a data voltage at the same time in the present exemplary embodiment.

Hereinafter, the liquid crystal panel assembly shown in FIG. 12 will be described with reference to FIG. 13. FIG. 13 is a layout view of a liquid crystal panel assembly according to another exemplary embodiment of the present invention. The liquid crystal panel assembly according to the present exemplary embodiment includes a lower panel (not shown) and an upper panel (not shown) facing each other, a liquid crystal layer (not shown) interposed between the two panels, and a pair of polarizers (not shown) attached at the outer surface of the panel. The layered structure of the liquid crystal panel assembly shown in FIG. 13 is identical to the layered structure of the liquid crystal panel assembly shown in FIG. 3 to FIG. 5.

The lower panel of the liquid crystal panel assembly shown in FIG. 13 will now be described. A gate conductor having a plurality of gate lines 121 and a plurality of storage electrode lines 131 are formed on an insulation substrate (not shown). Each of the gate lines 121 includes a plurality of pairs of first and second gate electrodes 124c and 124d and an end portion 129 thereof. Each storage electrode line 131 includes storage electrodes 137a and 137b. A gate insulating layer (not shown) is formed on the gate conductor 121. The first and second semiconductor islands 154c and 154d are formed on the gate insulating layer, and a plurality of ohmic contacts (not shown) are formed thereon. A data conductor having a plurality of pairs of data lines 171c and 171d and a plurality of first and second drain electrodes 175c and 175d are formed on the ohmic contacts. Each of the first and second data lines 171c and 171 d includes a plurality of the first and second source electrodes 173c and 173d and the ends 179c and 179d thereof. The first and second source electrodes 173c and 173d are connected to the first and second data lines 171c and 171d through the first and second interconnectors 174c, 174d, 178c, and 178d. A passivation layer (not shown) is formed on the data conductors 171c, 171d, 175c, and 175d and the exposed regions of the semiconductors 154c and 154d, and a plurality of contact holes 181, 182c, 182d, 185c, and 185d are formed on the passivation layer and the gate insulating layer. A plurality of pixel electrodes 191 having the first and second sub-pixel electrodes 191a and 191 and a plurality of contact assistants 81, 82c, and 82d are formed on the passivation layer. An alignment layer (not shown) is formed on the pixel electrode 191, the contact assistants 81, 82c, and 82d, and the passivation layer.

Hereinafter, the upper panel of the liquid crystal panel assembly shown in FIG. 13 will be described. A light blocking member (not shown), a plurality of color filters (not shown), an overcoat (not shown), a common electrode (not shown), and an alignment layer (not shown) are formed on an insulation substrate (not shown). The liquid crystal panel assembly according to the exemplary embodiment shown in FIG. 13 has half the gate lines 121 and two times the data lines 171c and 171d-compared to that shown in FIG. 10. The first and second TFTs Qc and Qd connected to the first and second sub-pixel electrodes 191a and 191b forming one pixel electrode 191 are connected to the same gate line 121 and different data lines 171 and 171 d. The numerous advantages of the liquid crystal panel assembly shown in FIG. 3 to FIG. 5 can be applied to the liquid crystal panel assembly shown in FIG. 13.

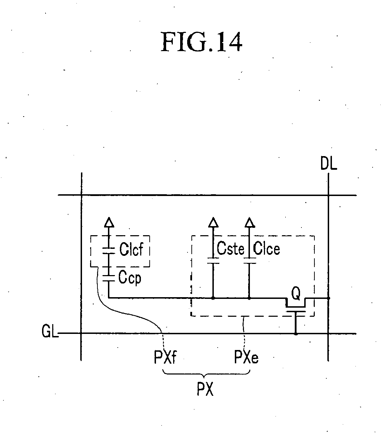

Hereinafter, a liquid crystal panel assembly shown in FIG. 8 will be described with reference to FIGS. 14-16. FIG. 14 is an equivalent circuit diagram of a pixel of a liquid crystal panel assembly according to another exemplary embodiment of the present invention. Referring to FIG. 14, the liquid crystal panel assembly includes signal lines having plurality of gate lines GL, a plurality of data lines DL, and a plurality of pixels PX connected thereto. Each pixel PX includes a pair of the first and second sub-pixels PXe and PXf, and a coupling capacitor Ccp interposed between the two sub-pixels PXe and PXf. The first sub-pixel PXe includes a switching element Q connected to a corresponding gate line GL and data line DL, a first liquid crystal capacitor Clce connected thereto, and a storage capacitor Cst. The second sub-pixel PXf includes a second liquid crystal capacitor Clef connected to the coupling capacitor Ccp.

The switching element Q is a three terminal element such as a thin film transistor included in the lower panel 100. The switching element Q includes a control terminal connected to the gate line GL, an input terminal connected to the data line DL, and an output terminal connected to the liquid crystal capacitor Clce, the storage capacitor Cste, and the coupling capacitor Ccp. The switching element Q supplies a data voltage from the gate line GL according to the gate signal from the data line DL to the first liquid crystal capacitor Clce and the coupling capacitor Ccp. The coupling capacitor Ccp transforms the magnitude of the voltage and transfers the transformed voltage to the second liquid crystal capacitor Clef. If a common voltage Vcom is supplied to the storage capacitor Cste and the capacitances of the capacitors Clce, Cste, Clcf, and Ccp are expressed by the same reference numerals, the voltage Ve charged at the first liquid crystal capacitor Clce and the voltage Vf charged at the second liquid crystal capacitor Clcf has the following relationship.

$$Vf=Ve\times[Ccp/(Ccp+Clcf)]$$

Since the value of Ccp/(Ccp+Clcf) is smaller than 1, the voltage Vf charged at the second liquid crystal capacitor (Clcf) is always smaller than the voltage Ve charged at the first liquid crystal capacitor (Clce). The relationship is equally applied although a voltage applied to the storage capacitor Cste is not the common voltage Vcom. The appropriate or effective ratio of the voltage Ve of the first liquid crystal capacitor Clce and the voltage Vf of the second liquid crystal capacitor Clef can be obtained by controlling the capacitance of the coupling capacitor Ccp.

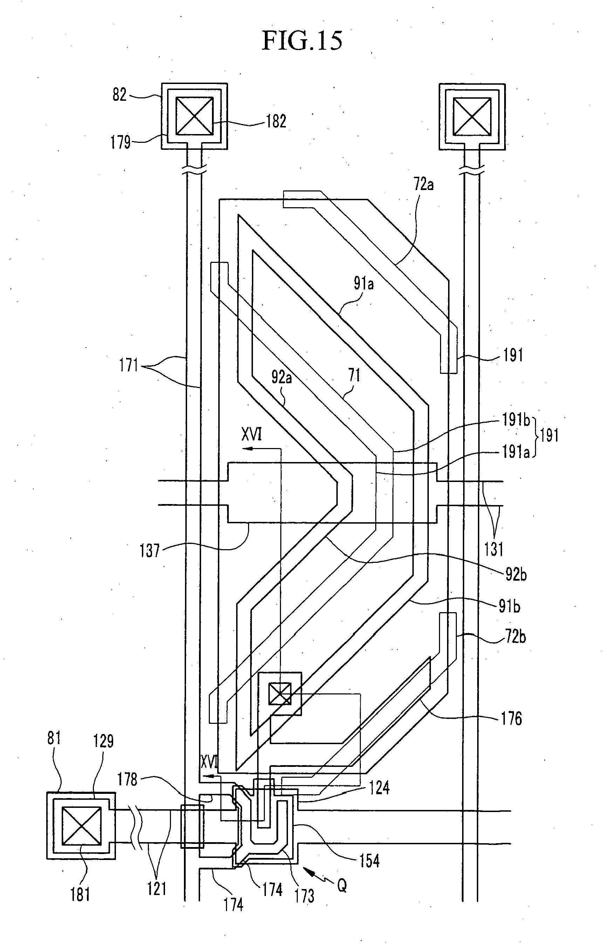

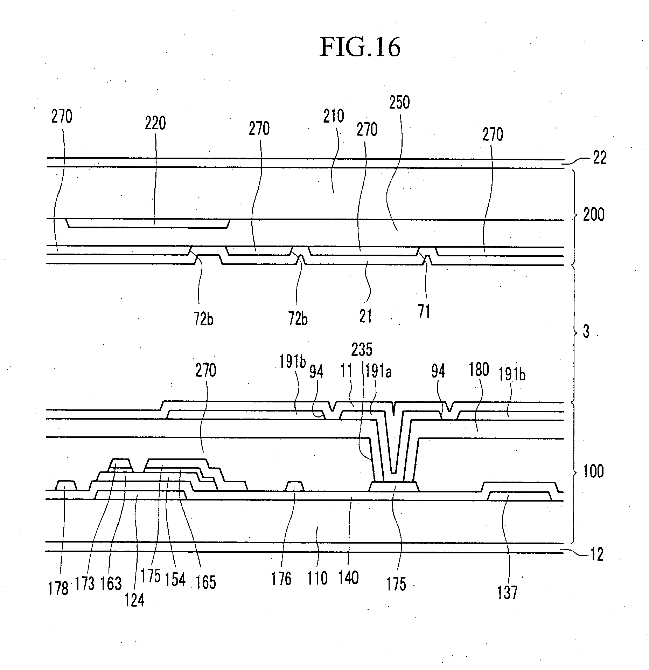

Now, the liquid crystal panel assembly according to an exemplary embodiment will be described with reference to FIGS. 15-16. FIG. 15 is a layout view of a liquid crystal panel assembly according to another exemplary embodiment of the present invention, and FIG. 16 is a cross-sectional view of the liquid crystal panel assembly of FIG. 15 taken along the line XVI-XVI. Referring to FIG. 15, the liquid crystal panel according to the present exemplary embodiment includes a lower panel 100, an upper panel 200 facing the low panel 100, a liquid crystal layer 3 interposed between the panels 100 and 200, and a pair of polarizers 12 and 22 attached at the outer surface of the display panel. The layered structure of the liquid crystal panel assembly according to the present exemplary embodiment is identical to that shown in FIG. 3 to FIG. 5.

Hereinafter, the lower panel 100 will now be described. A plurality of gate conductors having a plurality of gate lines 121 and storage electrode lines 131 are formed on an insulation substrate 110. Each gate line 121 includes a gate electrode 124 and an end portion 129 thereof, and the storage electrode line 131 includes a storage electrode 137. A gate insulating layer 140 is formed on a gate conductor 121. A semiconductor island 154 is formed on the gate insulating layer 140, and a plurality of ohmic contacts 163 and 165 are formed thereon. A data conductor having a plurality of data lines 171 and a plurality of drain electrodes 175 are formed on the ohmic contacts 163 and 165 and the gate insulating layer 140. Each data line 171 includes a plurality of source electrodes 173, and end portions 179 thereof. Each source electrode 173 is connected to a data line 171 through the first and second interconnectors 174 and 178. A passivation layer 180 is formed on the data conductors 171 and 175 and the exposed regions of the semiconductor 154, and a plurality of contact holes 181, 182, and 185 are formed on the passivation layer 180 and the gate insulating layer. A plurality of pixel electrodes 191 and a plurality of contact assistants 81 and 82 are formed on the passivation layer 180. An alignment layer 11 is formed on the pixel electrode 191, the contact assistants 81 and 82, and the passivation layer 180.

Hereinafter, the upper panel 200 will now be described. A light blocking member 220, an overcoat 250, a common electrode 270, and an alignment layer 21 are formed on an insulation substrate 210. The pixel electrode 191 and the common electrode 270 according to the present exemplary embodiment are similar to the pixel electrode 191 and the common electrode 270 in the liquid crystal panel assembly shown in FIG. 10 and FIG 13. However, the pixel electrode 191 according to the present embodiment is divided into a first sub-pixel electrode 191a and a second sub-pixel electrode 191b, unlike that shown in FIG. 3. The first sub-pixel electrode 191a is connected to the drain electrode 175 through a contact hole 185. The liquid crystal panel assembly according the present exemplary embodiment includes the drain electrode 175 and a coupling electrode 176. After the coupling electrode 176 extends substantially in parallel with the data line 171, the coupling electrode 176 curves and then extends along the lower cutout 72b of the common electrode 270. The coupling electrode 176 overlaps with the second sub-pixel electrode 191b. The coupling electrode 176 and the second sub-pixel electrode 191b form a coupling capacitor Ccp.

The liquid crystal panel assembly according to the present exemplary embodiment includes a plurality of color filters 230 formed under the passivation layer 180 of the lower panel instead of disposing the color filters at the upper panel 200, unlike the above-described liquid crystal panel assembly. The color filter 230 extends longitudinally in a vertical direction while periodically bending along the pixel electrode 191, and is not present at peripheral areas of the end portion 129 of the gate line 121 and the end portion 179 of the data line 171. A contact hole 185 passes through the color filter 230, and a through hole 235 that is larger than the contact hole 185 is formed at the color filter 230. The adjacent color filters 230 are overlapped on the data line 171, thereby having a function of a light blocking member that blocks light leakage between the pixel electrodes 191. In this case, the light blocking member can be omitted form the upper panel 200. Therefore, the manufacturing process can be simplified. A passivation layer (not shown) can be formed under the color filter 230, and the over coat 250 of the common electrode panel 200 can be omitted. The numerous advantages of the liquid crystal panel assembly shown in FIG. 3 to FIG. 5 can be applied to the liquid crystal panel assembly shown in FIGS. 15-16.

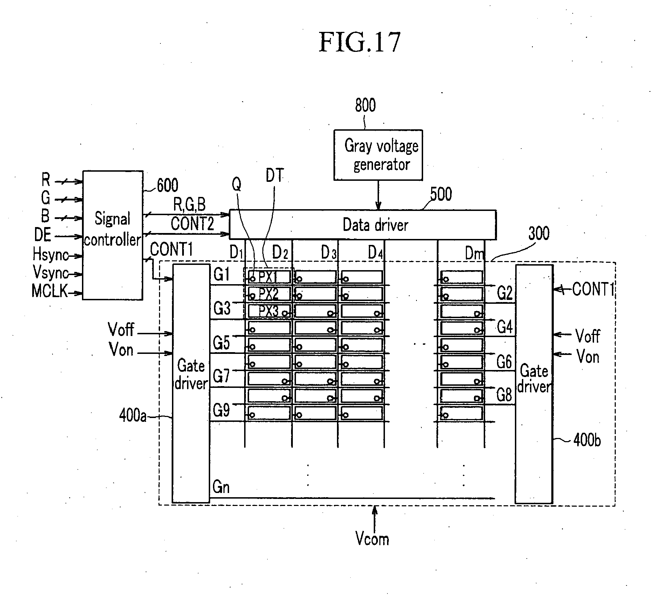

Hereinafter, a liquid crystal display according to another exemplary embodiment of the present invention will be described with reference to FIGS. 17-18. Referring to FIG. 17, the liquid crystal display according to an exemplary embodiment of the present invention includes a liquid crystal panel assembly 300, a pair of gate drivers 400a and 400b and a data driver 500 connected to the liquid crystal panel assembly 300, a gray voltage generator 800 connected to a storage electrode driver 700 and a data driver 500, and a signal controller 600 for controlling them.

In a view of an equivalent circuit, the liquid crystal panel assembly 300 includes a plurality of display signal lines and a plurality of pixels PX1, PX2, and PX3 connected to the display signal lines and arranged in a matrix shape. In the liquid crystal display of FIG. 17, each of the pixels PX1, PX2, and PX3 has a shape configured to be longer in a row direction, unlike the liquid crystal display shown in FIG. 1. Therefore, in the liquid crystal display according to the present exemplary embodiment, the number of data lines $G_1$-$G_n$ is three times that in the liquid crystal display shown in FIG. 3, and the number of data lines $D_1$-$D_m$ is 1/3 that in the liquid crystal display shown in FIG. 1. The pixels PX1, PX2 and PX3 adjacent in a row direction have three different colors of color filters, and the three different colors can be red, green, and blue. The pixels PX1 to PX3 of three primary colors form one dot DT as a basic unit for displaying an image.

Referring now briefly to FIG. 1, each pixel array is adjacent to two data lines, and the pixels PX1, PX2, and PX3 in each pixel array are alternatively connected to two data lines. In other words, a switching element Q of three adjacent pixels PX1, PX2, and PX3 in each pixel array is connected to the same data lines $D_1$ to $D_m$, and another switching element Q of the next two pixels PX1, PX2, and PX3 is connected to data lines $D_1$ to $D_m$ that are different from the data lines connected to the switching element Q of two previous pixels. However, the coupling relations of the switching element Q can be changed in various ways.

Gate drivers 400a and 400b are integrated at the liquid crystal panel assembly 300 with signal lines $G_1$ to $G_n$ and $D_1$ to $D_m$ and a thin film transistor switching element Q, and are respectively disposed at the left side and the right side of the liquid crystal panel assembly 300. The gate drivers 400a and 400b are alternatively connected to odd-numbered gate lines and even-numbered gate lines, and supply a gate signal formed of a combination of a gate-on voltage Von and a gate-off voltage Voff to gate lines $G_1$ to $G_n$. However, the gate driver 400a and 400b can be disposed at only one side of the assembly 300. Since the data driver 500, the signal controller 600, and the gray voltage generator 800 are identical to those in FIG. 1, further detailed descriptions thereof will be omitted.

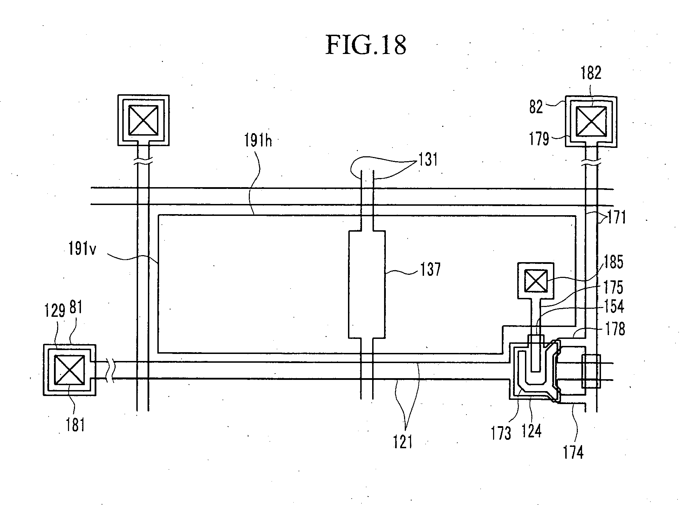

Hereinafter, a liquid crystal panel assembly of a liquid crystal display shown in FIG. 17 will be described with reference to FIG. 18. Referring to FIG. 18, the liquid crystal panel assembly according to the present exemplary embodiment includes a lower panel (not shown) and an upper panel (not shown) facing each other and a liquid crystal layer (not shown) interposed therebetween. The layered structure of the liquid crystal panel assembly according to the present exemplary embodiment is identical to that shown in FIGS. 3-5.

Hereinafter, the lower panel 100 will be described. A plurality of gate lines 121 are formed on an insulation substrate 110. Each gate line 121 includes a gate electrode 124 and an end portion 129 thereof. A gate insulating layer 140 is formed on the gate conductor 121. A semiconductor island 154 is formed on the gate insulating layer 140, and a plurality of ohmic contacts 163 and 165 are formed thereon. A data conductor having a plurality of data lines 171 and a plurality of drain electrodes 175, and a storage electrode line 131, are formed on the ohmic contacts 163 and 165 and the gate insulating layer 140. Each of the data lines 171 includes a plurality of source electrodes 173 and the end portions 179 thereof. The source electrodes 173 are connected to the data lines 171 through interconnectors 174 and 178. A storage electrode line 131 includes a storage electrode 137. A passivation layer 180 is formed on the data conductors 171 and 175 and the exposed regions of the semiconductor 154, and a plurality of contact holes 181, 182, and 185 are formed at the passivation layer 180 and the gate insulating layer 140. A plurality of pixel electrodes 191 and a plurality of contact assistants 81 and 82 are formed on the passivation layer. An alignment layer 11 is formed on the pixel electrodes 191, the contact assistants 81 and 82, and the passivation layer.

Hereinafter, the upper panel will be described. A light blocking member 220, a plurality of color filters 230, an overcoat 250, a common electrode 270, and an alignment layer 21 are formed on an insulation substrate 210. In the liquid crystal panel assembly of FIG. 18, each pixel electrode 191 has four main sides disposed in parallel with a gate line 121 or a data line 171, unlike the liquid crystal panel assembly of FIG. 3. Among them, the two horizontal sides 191h parallel with the gate line 121 are about three times longer than the adjacent two vertical sides 191v parallel with the data line 171. Therefore, the number of pixel electrodes 191 placed in each row is smaller and the number of pixel electrodes 191 placed in each column is larger compared to that having horizontal sides that are shorter than vertical sides. Since the entire number of the data lines 171 is reduced, the number of IC chips for the data drivers 500 is also reduced. Therefore, the material cost can be reduced. Although the number of gate lines 121 increases accordingly, the increase of the gate lines 121 is not a serious problem because the gate drivers 400a and 400b can be integrated in the assembly 300 with the gate lines 121, the data lines 171, and the thin film transistors. Since the IC chips for the gate drivers 400a and 400b are comparatively cheap, it is advantageous to reduce the number of IC chips for the data driver 500 even though the gate drivers 400a and 400b are mounted as IC chips. The pixel electrode 191 overlaps with a storage electrode line 131 such as the storage electrode 137, thereby forming a storage capacitor that enhances a capability of sustaining the voltage of a liquid crystal capacitor. The branch line of the storage electrode line 131 crosses the center of the pixel electrode 191 in a vertical direction, and includes a storage electrode 137 extended from the branch line to the left and the right. The storage electrode line 131 is placed at the same layer as a data conductor and is formed of the same material as the data conductor for the above-described arrangement.

According to one or more embodiments of the present invention, a pixel can be conveniently repaired not only when the thin film transistor of the liquid crystal display becomes deteriorated but also when the gate line and the data line are shorted. Therefore, the yield of the liquid crystal display can be improved.

While this invention has been described in connection with what is presently considered to be practical exemplary embodiments, it is to be understood that the invention is not limited to the disclosed embodiments, but, on the contrary, is intended to cover various modifications and equivalent arrangements included within the spirit and scope of the appended claims.

## Claims

1. A liquid crystal display, comprising:

   a substrate;
   a gate conductor formed on the substrate, the gate conductor including a gate line and a gate electrode;
   a data conductor including a data line crossing the gate line and a source electrode placed on the gate electrode; and
   a pixel electrode formed on the substrate,
   wherein the data line and the source electrode are connected with a first interconnector and a second interconnector.

2. The liquid crystal display of claim 1, wherein the first interconnector and the second interconnector are disposed with the gate line interposed therebetween.

3. The liquid crystal display of claim 1, wherein the first interconnector and the second interconnector do not overlap with the gate line.

4. The liquid crystal display of claim 1, wherein the first interconnector and the second interconnector are disposed with a crossing point of the data line and the gate line interposed therebetween.

5. The liquid crystal display of claim 1, wherein a first cutout is formed on the pixel electrode, the first cutout making an oblique angle with the gate line.

6. The liquid crystal display of claim 5, further comprising a common electrode disposed facing the pixel electrode,
   wherein a second cutout is formed on the common electrode, the second cutout being substantially parallel to the first cutout.

7. The liquid crystal display of claim 1, wherein the pixel electrode comprises two pairs of main edges parallel to the gate line and the data line, respectively.

8. The liquid crystal display of claim 1, wherein the pixel electrode comprises a first sub-pixel electrode and a second sub-pixel electrode that are separate from each other.

9. The liquid crystal display of claim 8,
   wherein the first sub-pixel electrode conducts a first voltage level and the second sub-pixel electrode conducts a second voltage level, and
   wherein the first voltage level of the first sub-pixel electrode and the second voltage level of the second sub-pixel electrode are different from each other.

10. The liquid crystal display of claim 9, wherein the first sub-pixel electrode and the second sub-pixel electrode are supplied with different data voltages obtained from a single image information.

11. The liquid crystal display of claim 10, further comprising:

    a first thin film transistor connected to the first sub-pixel electrode;
    a second thin film transistor connected to the second sub-pixel electrode;
    a first signal line connected to the first thin film transistor;
    a second signal line connected to the second thin film transistor; and
    a third signal line connected to the first thin film transistor and the second thin film transistor, the third signal line crossing the first signal line and the second signal line.

12. The liquid crystal display of claim 11, wherein the first thin film transistor and the second thin film transistor are turned on according to signals received from the first signal line and the second signal line, respectively, the first and second thin film transistors being configured to transfer signals from the third signal line.

13. The liquid crystal display of claim 11, wherein the first thin film transistor and the second thin film transistor are turned on according to signals received from the third signal line, the first and second thin film transistors being configured to transfer signals from the first signal line and the second signal line, respectively.

14. The liquid crystal display of claim 9, wherein the first sub-pixel electrode and the second sub-pixel electrode are capacitively coupled.

**15.** The liquid crystal display of claim 14, further comprising:

    a first thin film transistor connected to the first sub-pixel electrode;
    a first signal line connected to the first thin film transistor; and
    a second signal line connected to the first thin film transistor and crossing the first signal line.

**16.** The liquid crystal display of claim 1, wherein the pixel electrode has a first side parallel to the gate line and a second side adjacent to the first side, the second side being shorter than the first side.

**17.** The liquid crystal display of claim 16, wherein the first side is about three times longer than the second side.

**18.** A liquid crystal display, comprising:

    a substrate;
    a gate conductor formed on the substrate, the gate conductor including a gate line and a gate electrode;
    a data conductor including a data line crossing the gate line and a source electrode placed on the gate electrode; and
    a pixel electrode formed on the substrate, wherein the data line and the source electrode are connected with a plurality of interconnectors.

**19.** The liquid crystal display of claim 18, wherein at least a part of the interconnectors do not overlap with the gate conductor.

**20.** The liquid crystal display of claim 18, wherein the interconnectors are configured to be cut by a laser so that a voltage level may be continuously applied to the pixel electrode, the applied voltage level maintaining the pixel electrode in an inactive state.

# FIG.1

# FIG.2

# FIG.3

# FIG.4

# FIG.5

180    81    181          180    82    182

140    129    110    140    179    110

# FIG.6

# FIG.7a

185

171

178

VIIb

CL1

153

124

175

191

121

CL2

154

173

VIIb

174

# FIG.7b

11

171

180

160   121   153   140

# FIG.8

Clca    Clcb

3

270
230    200

100

PEa  PEb
PE

# FIG.9

# FIG.10

# FIG.11

# FIG.12

# FIG.13

# FIG.14

# FIG.15

# FIG.16

# FIG.17

# FIG.18

European Patent Office

**EUROPEAN SEARCH REPORT**

Application Number

EP 07 01 4464

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 95/12144 A (LITTON SYSTEMS CANADA [CA]; COE NIGEL M [CA]) 4 May 1995 (1995-05-04) * the whole document * | 1-4,7, 16-20 | INV. G02F1/1362 H01L21/77 |
| Y | | 5,6,8-15 | |
| Y | US 2006/158576 A1 (KIM HYUN-WUK [KR] ET AL) 20 July 2006 (2006-07-20) * figures 1,16 * * paragraph [0080] * | 5,6,8-15 | ADD. G02F1/1368 |
| A | WO 03/102682 A (SAMSUNG ELECTRONICS CO LTD [KR]; JEON JIN [KR]; LEE WON-KYU [KR]) 11 December 2003 (2003-12-11) * page 6, line 17 - line 26 * | 20 | |
| A | EP 0 458 173 A (DAIMLER BENZ AG [DE]) 27 November 1991 (1991-11-27) * the whole document * | 1-20 | |
| A | WO 97/05523 A (IMAGE QUEST TECHNOLOGIES INC [US]) 13 February 1997 (1997-02-13) * figures 7A,7B * | 1-20 | TECHNICAL FIELDS SEARCHED (IPC) G02F |

The present search report has been drawn up for all claims

| Place of search | Date of completion of the search | Examiner |
|---|---|---|
| Munich | 9 October 2007 | Girardin, François |

EPO FORM 1503 03.82 (P04C01)

## ANNEX TO THE EUROPEAN SEARCH REPORT
## ON EUROPEAN PATENT APPLICATION NO.

EP 07 01 4464

This annex lists the patent family members relating to the patent documents cited in the above-mentioned European search report.
The members are as contained in the European Patent Office EDP file on
The European Patent Office is in no way liable for these particulars which are merely given for the purpose of information.

09-10-2007

| Patent document cited in search report | | | Publication date | Patent family member(s) | | Publication date |
|---|---|---|---|---|---|---|
| WO 9512144 | A | | 04-05-1995 | NONE | | |
| US 2006158576 | A1 | | 20-07-2006 | NONE | | |
| WO 03102682 | A | | 11-12-2003 | AU | 2002329093 A1 | 19-12-2003 |
| | | | | CN | 1628264 A | 15-06-2005 |
| | | | | JP | 2005528641 T | 22-09-2005 |
| | | | | KR | 20030094452 A | 12-12-2003 |
| | | | | US | 2003234399 A1 | 25-12-2003 |
| EP 0458173 | A | | 27-11-1991 | DE | 4016443 A1 | 28-11-1991 |
| WO 9705523 | A | | 13-02-1997 | AU | 6641596 A | 26-02-1997 |
| | | | | CN | 1196803 A | 21-10-1998 |
| | | | | DE | 69624248 D1 | 14-11-2002 |
| | | | | DE | 69624248 T2 | 07-08-2003 |
| | | | | EP | 0842455 A1 | 20-05-1998 |
| | | | | JP | 11510272 T | 07-09-1999 |
| | | | | JP | 3273793 B2 | 15-04-2002 |
| | | | | US | 5874746 A | 23-02-1999 |
| | | | | US | 5737041 A | 07-04-1998 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020060069646